# EUROPÄISCHE PATENTANMELDUNG

(11) **EP 0 782 175 A2**
(43) Veröffentlichungstag der Anmeldung: **02.07.1997**
(21) Anmeldenummer: 96107217.0
(22) Anmeldetag: 07.05.1996
(51) Int. Cl.: H01L 21/00

(54) **Einrichtung zur Handhabung von scheibenförmigen Objekten**

(30) Priorität: 28.12.1995 DE 19549045
(71) Anmelder: JENOPTIK Aktiengesellschaft, D-07743 Jena (DE)
(72) Erfinder: Schultz, Klaus, 07745 Jena (DE); Beckert, Harald, 07747 Jena (DE); Lahne, Berndt, 07747 Jena (DE); Heinze, Manfred, 01109 Dresden (DE)
(74) Vertreter: Geyer, Werner, Dr.-Ing.

(57) **Zusammenfassung**

Bei einer Einrichtung zur Handhabung von scheibenförmigen Objekten besteht die Aufgabe, bei erhöhter Produktivität und frei wählbaren Transportwegen, mit geringem mechanischen Aufwand unter SMIF-Bedingungen ein hohes Maß an Positioniergenauigkeit zu gewährleisten.

Die Einrichtung weist mindestens eine Indexeinrichtung zur Bereitstellung und Entgegennahme der Objekte an einem, in einer Handhabungsebene gelegenen Bereitstellungs- und Entgegennahmeort und mindestens eine Transporteinrichtung zum Transport der scheibenförmigen Objekte zwischen dem Ort der Bereitstellung und Entgegennahme und der Arbeitsstation auf
Erfindungsgemäß ist die Arbeitsstation gemeinsam mit mindestens einer weiteren Arbeitsstation im wesentlichen koaxial zu einem Zentrum angeordnet, durch das eine Drehachse eines Wechslers verläuft.

Die Erfindung ist bei der Herstellung integrierter Schaltkreise anwendbar.

## Beschreibung

Die Erfindung betrifft eine Einrichtung zur Handhabung von scheibenförmigen Objekten mit mindestens einer Indexeinrichtung zur Bereitstellung und Entgegennahme der Objekte an einem, in einer Handhabungsebene gelegenen Bereitstellungs- und Entgegennahmeort und mindestens einem Umsetzer zum Transport der scheibenförmigen Objekte zwischen dem Ort der Bereitstellung und Entgegennahme und einer Arbeitsstation

Ständig kleiner werdende Strukturbreiten und damit sich erhöhende Anforderungen an die Reinheit der Umgebung der zu bearbeitenden Halbleiterscheiben führen in zunehmendem Maße zum Einsatz lokaler Reinräume in der Halbleiterfertigung.
Bei den für die SMIF-Technologie erforderlichen Handhabungskonzepten haben sich in der letzten Zeit Systeme durchgesetzt, die die Halbleiterscheiben für Transportzwecke nur noch an ihrer Rückseite kontaktieren.
Außerdem ist die Anwendung von Transportsystemen notwendig, die Kassetten in vertikaler Richtung aus einem Behälter entnehmen
Ein dazu geeignetes System ist z. B. in der DE 43 10 149 A1 beschrieben.

Von Nachteil ist es, daß mit einem derartigen Konzept die Transport- und Vorbereitungszeiten für Halbleiterscheiben begrenzt sind und die für einige Arbeitsstationen geforderte Positioniergenauigkeit nur mit großem Aufwand oder auf Grund hoher Getriebeuntersetzungen mit eingeschränkter Geschwindigkeit erreichbar ist.

Das trifft insbesondere auch dann zu, wenn ein Transportsystem mit mindestens einer Ein-/Ausgabestelle Halbleiterscheiben im orientierten Zustand auf einer Arbeitsstation ablegen und nach Abschluß der Arbeit zu einer der Ausgabestellen zurück transportieren soll und wenn neben den Ein-/Ausgabestationen und der Arbeitsstation weitere Stationen mit vorbereitenden Aufgaben vorgesehen werden sollen.
Eine typische Arbeitsstation kann z. B. ein Tischsystem eines Inspektionsgerätes sein Stationen zum Ausrichten der Halbleiterscheibe oder zur Identifizierung eines auf der Scheibe aufgebrachten Codes können ergänzend eingesetzt sein Eine freie Wählbarkeit des Transportweges der Halbleiterscheiben wirkt sich positiv auf die Flexibilität aus.

Aufgabe der Erfindung ist es deshalb, bei erhöhter Produktivität und frei wählbaren Transportwegen, mit geringem mechanischen Aufwand unter SMIF-Bedingungen ein hohes Maß an Positioniergenauigkeit zu gewährleisten.

Die Aufgabe wird erfindungsgemäß durch eine Einrichtung zur Handhabung von scheibenförmigen Objekten mit mindestens einer Indexeinrichtung zur Bereitstellung und Entgegennahme der Objekte an einem, in einer Handhabungsebene gelegenen Bereitstellungs- und Entgegennahmeort und mindestens einer Transporteinrichtung zum Transport der scheibenförmigen Objekte zwischen dem Ort der Bereitstellung und Entgegennahme und einer Arbeitsstation, dadurch gelöst, daß die Arbeitsstation gemeinsam mit mindestens einer weiteren Arbeitsstation im wesentlichen koaxial zu einem Zentrum angeordnet ist, durch das eine Drehachse eines Wechslers verläuft.

Der Wechsler weist zur hochgenauen Positionierung seiner Wechslerarme an den Arbeitsstationen zum Umladen der Objekte von einer Arbeitsstation zur anderen, neben einem Stufenantrieb zur Grobpositionierung, Mittel zur reproduzierbaren Positionierung in mindestens einer Sollposition auf.

Für die Grobpositionierung kann eine Codiereinrichtung verwendet werden, mit der durch mehrspurige Codierung sowohl die Ortsinformation über die Arbeitsstationen als auch die momentane Zuordnung der Wechslerarme zu den Arbeitsstationen bestimmt ist.

Vorteilhafterweise ist zur reproduzierbaren Positionierung des Wechslers in der Sollposition ein Paar gegeneinander verschiebbarer Zahnstangenabschnitte vorgesehen, die in ein Zahnrad gleicher Teilung eingreifen, das auf einer als Drehachse dienenden Zentralachse befestigt ist.

Außerdem ist es von Vorteil, wenn die Zahnstangenabschnitte greifende Elemente eines senkrecht zu seiner Kraftwirkungslinie verlängerbaren Parallelgreifers sind, der entgegengesetzt zu den greifenden Elementen in einem senkrecht zur Drehachse auf einer Linearführung geführten Lager um eine parallel zur Drehachse gerichtete Achse Y-Y drehbar ist

Zur Gewährleistung eines unbegrenzten Drehwinkels des Wechslers erfolgt eine Vakuumzuführung zu Vakuumhaltevorrichtungen an den Wechslerarmen im Inneren der als Drehachse dienenden Zentralachse, wobei Anschlüsse im Inneren der Zentralachse über ein Dichtungssystem mit feststehenden Vakuumanschlüssen außerhalb der Zentralachse gekoppelt sind.

Jede Indexeinrichtung ist zum vertikalen Verfahren zwischen zwei übereinanderliegenden Ebenen auf einer höhenverstellbaren Plattform befestigt, wobei die eine Ebene in einer ergonomischen Beladehöhe und die andere Ebene im Bereich der Handhabungsebene liegt, so daß die Indexeinrichtungen und die Transporteinrichtungen wirksam werden können

Es ist schließlich von Vorteil, wenn die Indexeinrichtungen mit ihren, für den Handhabungsprozeß offen gestalteten Seiten in einem ausreichend abdichtenden Labyrinthsystem geführt sind

Die Erfindung soll nachstehend anhand der schematischen Zeichnung näher erläutert werden. Es zeigen:
- Fig. 1: eine Draufsicht auf eine Handhabungseinrichtung
- Fig. 2: eine Seitenansicht der Handhabungseinrichtung
- Fig. 3: eine Seitenansicht eines Wechslers, teilweise im Schnitt
- Fig. 4: die Draufsicht auf den Wechsler
- Fig. 5: eine Codiereinrichtung zur Grobpositionierung des Wechslers
- Fig. 6: eine zur Feinpositionierung des Wechslers dienende Einrichtung

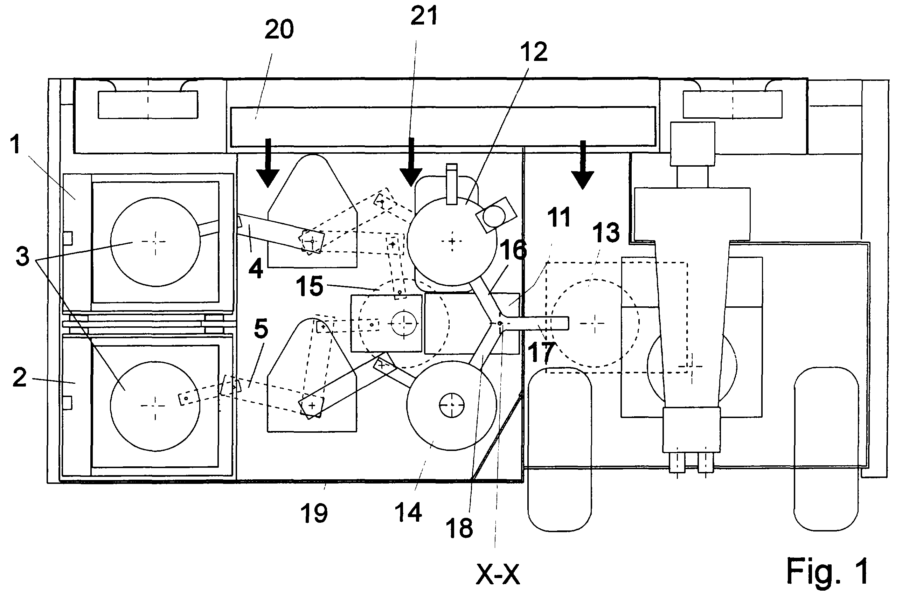

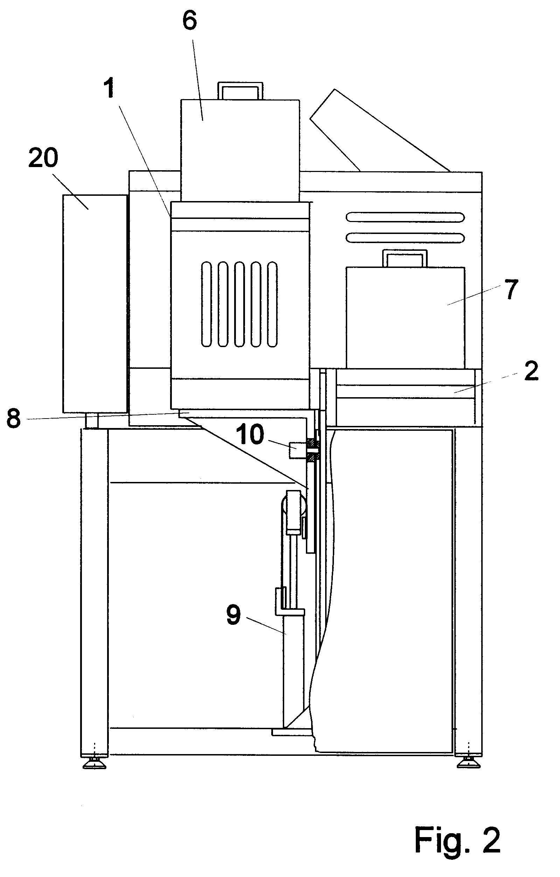

Bei der in den Figuren 1 und 2 schematisch dargestellten Anordnung eines Handhabungssystems sind zwei Ein- und Ausgabeeinrichtungen 1 und 2 vorgesehen, aus denen scheibenförmige Objekte 3, wie z. B. Halbleiterscheiben (oder Schablonen) durch Transporteinrichtungen 4 und 5 entnehmbar und wieder darin ablegbar sind. Die Ein- und Ausgabeeinrichtungen 1, 2 sind Indexeinrichtungen, mit denen Magazinfächer eines Magazins, das nach dem SMIF-Prinzip unter Reinraumbedingungen aus Magazinbehältern 6, 7 entnehmbar ist, gegenüber einer Handhabungsebene, in der die Transporteinrichtungen 4, 5 wirken, indexiert vertikal verstellbar sind. Dadurch werden die sich in den Fächern befindlichen Objekte 3 in der Handhabungsebene bereitgestellt bzw. das Zurücklegen in die Fächer gewährleistet.
Die Indexeinrichtungen selbst sind zum vertikalen Verfahren zwischen zwei übereinanderliegenden Ebenen auf Plattformen befestigt, von denen eine mit 8 bezeichnete sichtbar ist und die beide Fahrstuhlantriebe 9 besitzen. Ein Verriegelungszylinder 10 hat die Funktion der Plattformsicherung. Während die eine Ebene in einer ergonomischen Höhe der Beladung mit den Magazinbehältern 6, 7 dient, liegt die andere Ebene im Bereich der Handhabungsebene, so daß die Indexeinrichtungen und die Transporteinrichtungen 4, 5 wirksam werden können.
Die Reinraumbedingungen bleiben bei der Hohenverstellung ungestört, da die Indexeinrichtungen mit ihrer, für den Handhabungsprozeß offen gestalteten Seite in einem ausreichend abdichtenden Labyrinthsystem (nicht dargestellt) geführt sind.

Im wesentlichen koaxial zu einem Zentrum, durch das eine Drehachse X-X eines Wechslers 11 verläuft, sind Arbeitsstationen 12, 13 und 14 vorgesehen.
Im vorliegenden Beispiel ist die Arbeitsstation 12 eine Einrichtung zur Orientierung der Halbleiterscheibe in einer Ebene und um einen Winkel, die Arbeitsstation 13 ein Aufnahmetisch eines Inspektionsmikroskopes und die Arbeitsstation 14 ein Arbeitsplatz zur visuellen Ganzfeldinspektion.
Eine weitere Station 15, auf die beide Transporteinrichtungen 4, 5 einen Zugriff besitzen, ist ebenfalls im gleichen Abstand zum Zentrum angeordnet. Während die anderen Arbeitsstationen 12, 13, 14 vorteilhafterweise jeweils in einem Winkelabstand von 120 ° angeordnet sind, liegt die Station 15 in einer Zwischenlage.

Durch die Anordnung der Arbeitsstationen 12, 13, 14 sowie der Station 15 und die Verwendung von Indexeinrichtungen für die Objektbereitstellung, wodurch uneffektive Bewegungen der Transporteinrichtungen 3, 4 vermieden werden, wird eine hocheffektive und flexible Handhabung der Objekte 3 zwischen den verschiedenen Arbeitsstationen 12, 13, 14 gewährleistet. Die Objekte 3 können beliebig aus jeder der Ein- und Ausgabeeinrichtungen 1, 2 entnommen und in dieselbe oder in die jeweils andere Einrichtung zurückgeführt werden. Die Station 15 dient dem Zweck des Zwischenablageplatzes, von dem ein mit der einen Transporteinrichtung abgelegtes Objekt 3 mit der anderen aufgenommen werden kann. Der Wechsler 11, der um jeweils 120 ° versetzt angeordnete Wechslerarme 16, 17, 18 besitzt, gewährleistet durch seine beidseitige Drehbarkeit das beliebige Umsetzen der Objekte 3 zwischen den Arbeitsstationen 12, 13, 14

Die gesamte Einrichtung ist von einer Einhausung 19 umgeben, deren Innenraum im wesentlichen in zwei übereinanderliegende Teilräume unterteilt ist. Während der obere Teilraum als Handhabungsraum dient, ist im unteren Teilraum ein Großteil der Antriebselemente untergebracht. Eine Luftaufbereitungsanlage 20 dient zur Erzeugung von Reinstluft, die als turbulenzarmer Luftstrom 21 die Teilräume durchströmt, wobei besonders eine gemäß DE 43 10 149 A1 erzeugte, vom oberen zum unteren Teilraum gerichtete Strömungskomponente das Eindringen von Partikeln in den Handhabungsraum verhindert.

Der Wechsler 11, dessen Wechslerarme 16, 17, 18 in der Anzahl den Arbeitsstationen 12, 13, 14 entsprechen, ist durch anordnungsmäßige Gestaltung nicht nur zur einer hocheffektiven und flexiblen, sondern auch zu einer positionsgenauen Handhabung der Objekte 3 in der Lage.

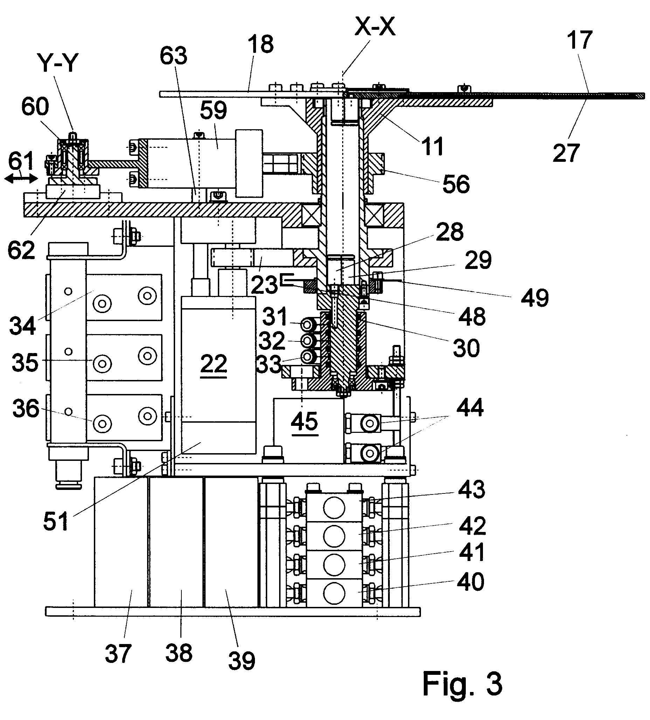

Zu diesem Zweck dient die erfindungsgemäße Ausführung gemäß den Figuren 3 bis 5. Zum Antrieb des in beide Richtungen drehbaren Wechslers 11 (im vorliegenden Fall in 120 °-Stufen) ist ein Motor 22 mit einem dazugehörigen Zahnriemengetriebe 23 vorgesehen. Die Wechslerarme 16, 17, 18 enthalten an ihren vorderen Enden Vakuumhaltevorrichtungen 24, 25 und 26 und in ihrem Inneren verlaufende Kanäle, von denen nur der Kanal 27 dargestellt ist.

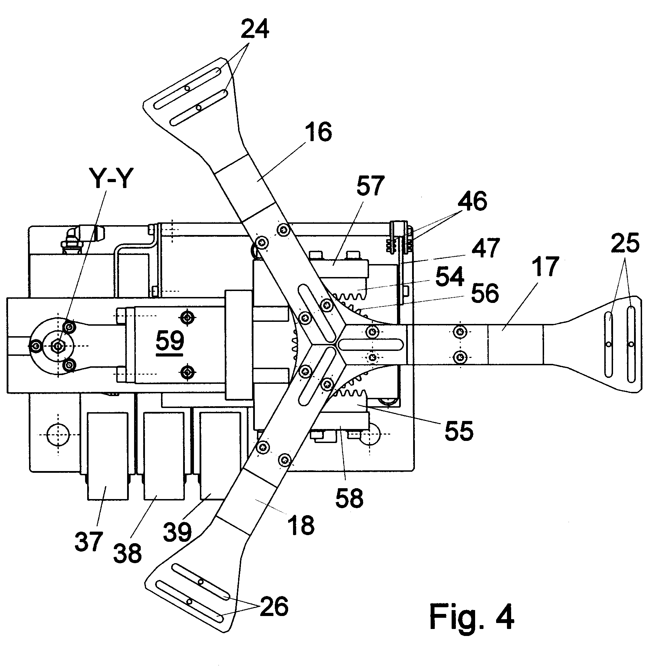

Zur Gewährleistung eines unbegrenzten Drehwinkels des Wechslers 11 erfolgt die Vakuumzuführung zu den Kanälen über nichtdargestellte Schlauchverbindungen im Inneren einer als Drehachse X-X dienenden Zentralachse. Anschlüsse 28, 29 (ein Anschluß ist nicht sichtbar) im Inneren der Zentralachse sind über ein Dichtungssystem 30 mit feststehenden Vakuumanschlüssen 31, 32, 33 außerhalb der Zentralachse gekoppelt. Die Vakuumversorgung wird komplettiert durch eingangs vorgesehene Ventile 34, 35, 36 und dazugehörigen Vakuumsensoren 37, 38, 39 sowie Drosseln 40, 41, 42. Eine Drossel 43 ist zur Belüftung der Vakuumhaltevorrichtungen 24, 25, 26 vorgesehen. Ein über Drossein 44 gesteuerter Hubzylinder 45 dient zur notwendigen Höhenverstellung des Wechslers 11 beim Wechselvorgang. Ein in Fig. 4 dargestellter Sensor 46 steuert den über eine Kulisse 47 angezeigten Hub.

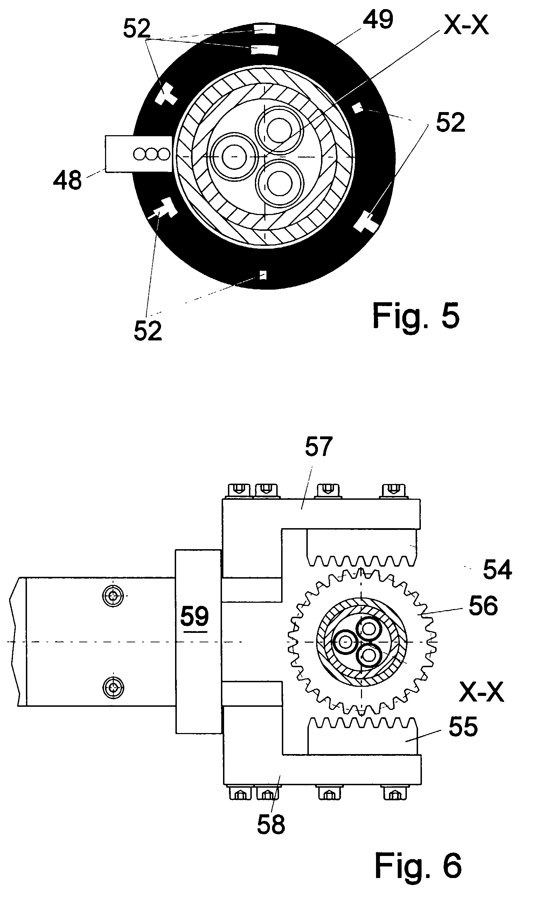

Ein Sensor 48 und eine Signalscheibe 49 bilden eine Codiereinrichtung gemäß Fig. 5 zur gezielten Grobpositionierung des Wechslers 11. Die durch den Motor 22 eingeleitete Rotation des Wechslers 11 bei einem Initialisierungsvorgang wird durch den Sensor 48 und einem Referenzpunkt auf der Signalscheibe 49 überwacht. Bei Erreichen des Referenzpunktes wird ein mit einem Encoder 51, der am rückwärtigen Achsenende des Motors 22 angebracht ist (siehe Fig. 3), verbundener nichtdargestellter Schrittzähler auf Null gesetzt. Die weitere Überwachung und Steuerung der Drehbewegung erfolgt mit Hilfe der vom Encoder 51 gelieferten Weginformation.
Zur Erhöhung der Sicherheit wird die Signalscheibe 49 neben dem Referenzpunkt mit Fenstern 52 versehen. Durch eine dreispurige Anordnung der Fenster 52 wird in Verbindung mit einem dreispurigen optoelektronischen Sensor 53 neben der Ortsinformation der drei Arbeitsstationen 12, 13, 14 und der Zwischenposition, an der sich die Station 15 befindet, auch die momentane Zuordnung der drei Wechslerarme 16, 17, 18 zu den Arbeitsstationen 12, 13, 14 signalisiert.

Zur Erreichung der geforderten Positioniergenauigkeit beim Umladen der Objekte 3 zwischen den Arbeitsstationen 12, 13, 14 weist der Wechsler 11 neben dem Stufenantrieb zur Grobpositionierung Mittel zur reproduzierbaren Positionierung in einer Sollposition auf. Ein Paar gegeneinander verschiebbarer Zahnstangenabschnitte 54, 55 greift in ein auf der Zentralachse befestigtes Zahnrad 56 gleicher und durch drei teilbarer Teilung ein. Die Zahnstangenabschnitte 54, 55 sind Teile greifender Elemente 57, 58 eines senkrecht zu seiner Kraftwirkungslinie verlängerbaren Parallelgreifers 59, der entgegengesetzt zu den greifenden Elementen 57, 58 in einem Lager 60 um eine parallel zur Drehachse X-X gerichtete Achse Y-Y drehbar ist.
Das Lager 60 ist in einer Richtung 61 senkrecht zur Drehachse X-X auf einer Linearführung 62 geführt. Elastische Kopplungselemente 63 übernehmen die Lagesicherung des Parallelgreifers 59 und lassen eine ungehinderte Rotation des Wechslers 11 im nicht greifenden Zustand zu.
Mit dieser technischen Lösung ist die zwangsfreie Krafteinleitung auf das Zahnrad 56 der Zentralachse und deren reproduzierbare Fixierung gewährleistet.

Um Teilungsfehler zu eliminieren, erfolgt die Übergabe der Objekte 3 von einer Arbeitsstation zur anderen immer mit dem gleichen Wechslerarm.

Eine andere Möglichkeit liegt in der Ermittlung des systematischen Fehlers zwischen den drei Wechslerarmen und der Berücksichtigung dieser Fehler bei der Positionierung der Arbeitsstation.
Der systematische Winkelfehler, der bei dieser Arbeitsweise auftreten kann, wird durch einen entsprechenden Offsetwert bei der Orientierung des Objektes 3 korrigiert.

Da in vielen Fällen die Bewegungsfreiheit durch aufnehmende Elemente der einzelnen Arbeitsstationen eingeschränkt und die alleinige rotatorische Bewegung nicht möglich ist, wird in der jeweiligen Sollposition der rotatorischen Bewegung eine lineare Bewegung überlagert.
Zu diesem Zweck befindet sich auf jedem der drei Wechslerarme 16, 17, 18 je ein in radialer Richtung bewegliches Aufnahmeelement. Im Normalfall ist dieses fixiert (Klemmung oder Feder). In einer oder mehreren Sollpositionen des Wechslers 11 kann mit Hilfe eines oder mehrerer feststehender Antriebe eine lineare Bewegung eingeleitet werden.

Zur Schwingungsisolation sind die Handhabungseinheit und das Inspektionsmikroskop auf einer gemeinsamen Basisplatte angeordnet, die Bestandteil eines Schwingungsisolationssystems ist.

Die Arbeitsweise der Einrichtung sei an einem Beispiel für den Transport eines Objektes 3 erläutert.
Nach dem Aufsetzen bzw. Wechseln der Magazinbehälter 6, 7 in einer ergonomischen Beladehöhe in der Ebene E1 werden beide Indexeinrichtungen mit Hilfe der Fahrstuhlantriebe 10 aus der Beladehöhe in die Ebene E2 im Bereich der Handhabungsebene gefahren.

Während dieser Vertikalbewegung der Indexeinrichtungen werden die Magazinbehälter 6, 7 geöffnet, und nach Erreichen einer oberen Endlage erfolgt die Inventur in beiden Indexeinrichtungen. Die Inventur dient der Ermittlung der Belegung in den Magazinen, sowie der Ermittlung der Lage der Objekte 3 bzw. der freien Magazinfächer gegenüber der Handhabungsebene. Nach der Inventur wird die Belegung einem übergeordneten Rechner mitgeteilt und die zu inspizierenden Objekte 3 können ausgewählt werden.

Ein erstes Objekt 3 aus der Ein- und Ausgabestation 1 wird mit Hilfe des Transportarmes 4 entnommen und zur ersten Arbeitsstation 12 transportiert. Beide Transportarme 4, 5 besitzen wie die Wechslerarme 16, 17, 18 Vakuumhaltevorrichtungen, von denen die am Transportarm 4 befindliche nach Erreichen der ersten Arbeitsstation 12 belüftet und so das Objekt 3 übergeben wird. Da es sich im vorliegenden Fall um eine Ausrichtstation handelt, erfolgt nach dem Ansaugen des Objektes 3 dessen Orientierung in der x-y-Ebene und eine Winkelorientierung.
Die zweite Arbeitsstation 13, ein Mikroskoptisch, fährt in eine Wechsellage, die der konzentrischen Lage aller Arbeitsstationen zur Drehachse X-X entspricht. Durch eine Aufwärtsbewegung des Wechslers 11 mittels des Hubzyliders 45 wird sowohl das ausgerichtete Objekt als auch ein, auf dem Mikroskoptisch befindliches Objekt aufgenommen. Beide Objekte werden an der Rückseite durch die Vakuumhaltevorrichtung am jeweiligen Wechslerarm fixiert

Bei der sich anschließenden 120 °-Drehung des Wechslers 11 erfolgt der gleichzeitige Transport des Objektes von der Ausrichtstation zum Mikroskoptisch und vom Mikroskoptisch zur weiteren Arbeitsstation 14.
An beiden Vakuumhaltevorrichtungen wird das Vakuum abgeschalten und mit einer Abwartsbewegung erfolgt die Übergabe der Objekte an die jeweilige Arbeitsstation

Durch den gleichzeitigen Objektewechsel mit einer Wechselbewegung wird die Wechselzeit auf ein Minimum reduziert.

Während der sich nunmehr anschließenden Inspektionszeit erfolgt der Transport des Objektes von der Arbeitsstation 14 mit der Transporteinrichtung 5 zur Ein- und Ausgabeeinrichtung 2. Zu diesem Zweck wird das Vakuum der Vakuumhaltevorrichtung eingeschalten und bei gleichzeitiger Aufwärtsbewegung wird das Objekt von der Arbeitsstation 14 übernommen und in das gewählte Magazinfach abgelegt. Zeitgleich erfolgt der Transport des nächsten Objektes zur Ausrichtstation.
Der hier beschriebene Transportweg für die Objekte 3 ist nur ein Beispiel. Wie unter anderem aus der gestrichelten Darstellungweise der Transportarme erkennbar ist, können mit der erfindungsgemäßen Einrichtung in flexibler Weise auch eine Vielzahl anderer Transportwege realisiert werden, wozu auch insbesondere, wie bereits beschrieben, die Station 15 zu benutzen ist. Der in beiden Richtungen drehbare Wechsler 11 kann einen beliebigen Objekteaustausch vollziehen.

Es ist außerdem möglich, die hier lediglich als Zwischenablageplatz vorgesehene Station 15 als Arbeitsstation zum Sortieren und Mischen der Objekte zu benutzen.

Nachdem des letzte Objekt inspiziert wurde, werden beide Magazine in die Magazinbehälter 6, 7 gefahren. Die Magazinbehälter 6, 7 werden verriegelt und gleichzeitig werden die Indexeinrichtungen wieder in die Beladehöhe gefahren.

## Patentansprüche

1. Einrichtung zur Handhabung von scheibenförmigen Objekten mit mindestens einer Indexeinrichtung zur Bereitstellung und Entgegennahme der Objekte an einem, in einer Handhabungsebene gelegenen Bereitstellungs- und Entgegennahmeort und mindestens einer Transporteinrichtung zum Transport der scheibenförmigen Objekte zwischen dem Ort der Bereitstellung und Entgegennahme und einer Arbeitsstation, dadurch gekennzeichnet, daß
die Arbeitsstation (12) gemeinsam mit mindestens einer weiteren Arbeitsstation (13, 14) im wesentlichen koaxial zu einem Zentrum angeordnet ist, durch das eine Drehachse (X-X) eines Wechslers (11) verläuft.

2. Einrichtung nach Anspruch 1, dadurch gekennzeichnet, daß
der Wechsler (11) zur hochgenauen Positionierung seiner Wechslerarme (16, 17, 18) an den Arbeitsstationen (12, 13, 14) zum Umladen der Objekte (3) von einer Arbeitsstation zur anderen, neben einem Stufenantrieb zur Grobpositionierung, Mittel zur reproduzierbaren Positionierung in mindestens einer Sollposition aufweist.

3. Einrichtung nach Anspruch 2, dadurch gekennzeichnet, daß
die Grobpositionierung über eine Codiereinrichtung erfolgt, mit der durch mehrspurige Codierung sowohl die Ortsinformation über die Arbeitsstationen (12, 13, 14, 15) als auch die momentane Zuordnung der Wechslerarme (16, 17, 18) zu den Arbeitsstationen (12, 13, 14) bestimmt ist.

4. Einrichtung nach einem der Ansprüche 1 - 3, dadurch gekennzeichnet, daß
zur reproduzierbaren Positionierung des Wechslers (11) in der Sollposition ein Paar gegeneinander verschiebbarer Zahnstangenabschnitte (54, 55) vorgesehen ist, die in ein Zahnrad gleicher Teilung eingreifen, das auf einer als Drehachse (X-X) dienenden Zentralachse befestigt ist.

5. Einrichtung nach Anspruch 4, dadurch gekennzeichnet, daß
die Zahnstangenabschnitte (54, 55) greifende Elemente (57, 58) eines senkrecht zu seiner Kraftwirkungslinie verlängerbaren Parallelgreifers (59) sind, der entgegengesetzt zu den greifenden Elementen (57, 58) in einem senkrecht zur Drehachse X-X auf einer Linearführung (62) geführten Lager (60) um eine parallel zur Drehachse X-X gerichtete Achse Y-Y drehbar ist.

6. Einrichtung nach einem der Ansprüche 1 - 5, dadurch gekennzeichnet, daß
zur Gewährleistung eines unbegrenzten Drehwinkels des Wechslers (11) eine Vakuumzuführung zu Vakuumhaltevorrichtungen (24, 25, 26) an den Wechslerarmen (16, 17, 18) im Inneren der als Drehachse X-X dienenden Zentralachse erfolgt, wobei Anschlüsse (28, 29) im Inneren der Zentralachse über ein Dichtungssystem (30) mit feststehenden Vakuumanschlüssen (31, 32, 33) außerhalb der Zentralachse gekoppelt sind.

7. Einrichtung nach Anspruch 1, dadurch gekennzeichnet, daß
jede Indexeinrichtung zum vertikalen Verfahren zwischen zwei übereinanderliegenden Ebenen (E1, E2) auf einer höhenverstellbaren Plattform (8, 9) befestigt ist, wobei die eine Ebene (E1) in einer ergonomischen Beladehöhe und die andere Ebene (E2) im Bereich der Handhabungsebene liegt, so daß die Indexeinrichtungen und die Transporteinrichtungen (4, 5) wirksam werden können.

8. Einrichtung nach Anspruch 7, dadurch gekennzeichnet, daß
die Indexeinrichtungen mit ihren, für den Handhabungsprozeß offen gestalteten Seiten in einem ausreichend abdichtenden Labyrinthsystem geführt sind.
